(19) Europäisches Patentamt
European Patent Office
Office européen des brevets

(11) **EP 1 879 190 A1**

(12) **EUROPEAN PATENT APPLICATION**

(43) Date of publication:
**16.01.2008 Bulletin 2008/03**

(51) Int Cl.:
**G11B 20/10** (2006.01)

(21) Application number: **06117228.4**

(22) Date of filing: **14.07.2006**

(84) Designated Contracting States:
**AT BE BG CH CY CZ DE DK EE ES FI FR GB GR HU IE IS IT LI LT LU LV MC NL PL PT RO SE SI SK TR**
Designated Extension States:
**AL BA HR MK YU**

(71) Applicant: **DEUTSCHE THOMSON-BRANDT GMBH**
**78048 Villingen-Schwenningen (DE)**

(72) Inventor: **Orcic, Krunoslav**
**78048 Villingen-Schwenningen (DE)**

(74) Representative: **Kurth, Dieter et al**
**Deutsche Thomson-Brandt GmbH,**
**European Patent Operations,**
**Karl-Wiechert-Allee 74**
**30625 Hannover (DE)**

(54) **Optical disc playback apparatus and method to improve the playability of an optical disc**

(57) An optical disc playback apparatus and a method to improve data detection performance or so-called playability of an optical disc are recommended, which remove low frequency noise caused by a deteriorated signal level of a high frequency signal read from the optical disc and provide a constant group delay for frequency signals in the high frequency signal representing the information stored on the disc for an improved playability of the disc. This is achieved by a tuned filter providing a difference signal from the high frequency signal and the high frequency signal after passing a low pass filter. According to embodiments of the invention, the low pass filter is a 2nd order elliptical filter.

Fig. 3

**Description**

FIELD OF THE INVENTION

The present invention relates in general to an optical disc playback apparatus and to a method to improve data detection performance or so-called playability of an optical disc, which contains digitally stored information of for example audio, video or computer data.

BACKGROUND OF THE INVENTION

Disc-like optical recording media as e.g. optical discs, magneto- optic discs, read-only types, write-once recordable types and rewriteable types are well known. Everyday handling damage, such as dust, fingerprints, and tiny scratches, affects the reproduction of recorded information and causes errors. In optical disc drives, an optical scanning device scans the data tracks of a disc by means of a light beam. Using an objective lens, the light beam is focused onto the disc by a focusing regulation circuit. A tracking regulation circuit guides the optical scanning device such that the light beam is always guided along the data tracks of the disc. That means a problem in disc drives for playing optical discs is that the optical disc may suffer from mechanical defects like scratches, fingerprints, dust and dirty areas that obscure the information layer. As a result, the output data stream contains errors. Although optical disc recording and reproducing systems are provided with error correction systems as e.g. the well known Reed-Solomon-Code and interleaving, especially fingerprints, dirty areas and scratches cause error bursts, which avoid a complete reconstruction of the recorded information.

The signal that is read from the optical disc and contains the recorded information is a weak HF-current-signal and requires current to voltage conversion, amplification and waveform shaping and it is already known to set a time constant corresponding to the reproduction speed to the amplifier and a cut-off frequency corresponding to the reproduction speed to the high pass filter separating the information signal from servo signals to compensate a deteriorated signal level due to missing of a signal caused by a defect such as a flaw or due to dirt such as fingerprint. Furthermore, a filter for eliminating low frequency components of a signal obtained from the optical disc already has been disclosed, the filter having cut-off frequencies of plural levels and a programmed control for retrying reading out of data from a portion of a defect of the optical disc by changing the cut-off frequency of the filter is used when the data can not be properly read out from that portion of the optical disc under the current rotational speed. The cut-off frequency of the filter is raised by one level by a switch to retry of the reading out of the data from that portion. When the data can not be still read out from that portion, the rotation speed of the optical disc is stepwise lowered by one level to retry the reading out of the data. A portion of a defect has to be read several times with reduced speed that reduces the available data rate and requires a large memory to avoid interruptions during reproducing the information stored on the disc.

SUMMARY OF THE INVENTION

It is therefore an aspect of the present invention to improve the playability of an optical disc such that the amount of errors in the information signal read from the disc, due to defects as fingerprints and fine scratches is reduced.

This is achieved by means of the features specified in independent claims. Advantageous embodiments of the invention are disclosed in the dependent claims.

The problem which has to be coped with is the contradiction between using a high pass filter, which removes low frequency components of a signal obtained from the optical disc and to keep the information included in the signal obtained from the optical disc unmodified. Therefore, it is an aspect of the invention to provide a specific high pass filter, in the following named as tuned filter, which removes low frequency components of a signal obtained from the optical disc and keeps the information included in the signal obtained from the optical disc unmodified.

The information is stored as a pattern of pits and lands in the disc and the length of the pits and lands are detected by an optical pick-up and transformed to electrical digital symbols, used to reconstruct the stored information. Different symbols called 3T...14T are used for pits and lands on the disc. The T is a variable defined by the ration of pit length to the velocity at which the laser beam travels over the disc. Each symbol is represented by an electrical pulse having a width of 3...14 clock periods. The size of T varies according to the physical length of the pit, and is dependent upon the definition of the pit in the control bytes in each sector. The lengths of the pits that represent a given number of binary bits are the same regardless of placement on the disc. The overall quality of a disc system is based on, amongst others, the amount of jitter in the system. The jitter could be caused by a bad recording or by the disc player. If the jitter is too large, the optical disc playback apparatus can not separate the various symbols, and the result will be a bad sound or wrong data interpretation. That means that the information included in the high frequency signal obtained from the optical disc has to be kept unmodified even if the signal is deteriorated by fingerprints or small scratches. The high frequency signal obtained from the optical disc has low frequency noise in the area of fingerprints or small scratches which decrease the quality of the high frequency signal provided by the pickup, and also the quality of the channel input signal representing the symbols 3T...14T is decreased due to the deteriorated signal level of the high frequency signal read from the optical disc. The low frequency part causes an asymmetry in the high frequency signal, increases jitter and decreases the so-called playability of the disc. Playability of an optical disc is a measure of the player's ability to cope with discs that have errors, manufacturing defects, fingerprints or surface damage. Fingerprints or small scratches decrease the level of the high frequency signal and increase the level of the low frequency noise which disturb the correct work of the waveshaper or so-called data slicer and generates large jitter. Result is a bad separation of the different symbols 3T...14T. The high frequency signal detected from the disc is a heterogeneous signal due to disc irregularities and the waveshaper detects zero-cross points of eye pattern in the high frequency signal and transforms the signal into a square wave signal. Of course, low frequency noise can be reduced or eliminated by modifying the high pass filter or inserting a smaller capacitor between the high frequency output of the pickup and an analog front-end input, however, it destroys also the phase characteristic of the input path and of course the group delay characteristic in the high frequency signal representing the information stored on the disc. In addition, the modified high pass filter has a negative impact on the disc reproducing quality and other disc imperfections as large scratches, black dots ect..

Therefore, an optical disc playback apparatus and a method to improve data detection performance or so-called playability of an optical disc are recommended to improve the playability of an optical disc such that the amount of errors in the information signal read from the disc, due to defects as fingerprints and fine scratches is reduced.

This is achieved by a tuned filter forming a frequency translating device, which removes low frequency components of a signal obtained from the optical disc and keeps the information included in the signal obtained from the optical disc unmodified. The tuned filter is adapted to the type of optical disc and the current reading speed of the optical disc and removes low frequency noise caused by a deteriorated signal level of the high frequency signal read from the optical disc and has a constant group delay for frequencies in the high frequency signal read from the optical disc representing the information stored on the disc for an improved playability of the disc. The tuned filter may be realised by an analog or a digital filter, which provides the difference between the high frequency signal and the high frequency signal passing a low pass filter, which according to an embodiment of the invention is a $2^{nd}$ order elliptical filter. Low frequency noise caused by a deteriorated signal level of the high frequency signal read from the optical disc is removed and a constant group delay for frequencies in the high frequency signal representing the information stored on the disc is provided by forming a difference signal from the high frequency signal read from the optical disc and the high frequency signal passing the low pass filter. In the embodiment, wherein the tuned filter is realised by a digital filter, the digital filter is connected via an analog/digital converter to the optical pickup providing the high frequency signal representing the information stored on the disc. The digital filter is a finite-impulse-response digital filter forming the difference between the high frequency signal and the high frequency signal passing the low pass filter. The cut-off frequency of the low pass filter is the input parameter to calculate filter coefficients adapted to the type of optical disc and the current reading speed of the optical disc. The filter coefficients can be continuously adapted so that an universal solution adaptable to disc type and current disc speed is formed, which increases the quality of the signal reproduced from the disc as well as the playability of the disc. Multiple re-reads of data from a portion of a defect on the optical disc are not necessary because optimised conditions are already ensured during first time reading information from the disc. The memory to avoid interruptions during reproducing the information stored on the disc can be reduced due to the improved playability of the disc and the tuned filter according to the invention requires only little outlay. Features and advantages of the present intention will become more apparent from the following detailed description of embodiments of the present invention when taken in conjunction with the accompanying drawings.

BRIEF DESCRIPTION OF THE DRAWINGS

In the drawings:

FIG. 1 is a block diagram showing the implementation of a first tuned filter in the signal pass between pickup and input of a front end in an optical disc playback apparatus according to the present invention,

FIG. 2 is a block diagram showing the implementation of a digital tuned filter in the signal pass between pickup and input of an digital front end in an optical disc playback apparatus according to the present invention,

FIG. 3 is circuit diagram showing the elements of the first tuned filter according to the present invention,

FIG. 4 is a block diagram showing the structure of an FIR filter used a tuned filter according to the invention,

FIG. 5 is a diagram showing the characteristic of a tuned filter according to Fig. 3 as magnitude over frequency,

FIG. 6 is a diagram showing the characteristic of a tuned filter according to Fig. 3 as group delay dependent on the frequency,

FIG. 7 is a diagram showing the characteristic of a known high pass filter as magnitude dependent on the frequency,

FIG. 8 is a diagram showing the characteristic of the known high pass filter as group delay with respect to the frequency,

FIG. 9 is a diagram showing the characteristic of a digital filter according to the invention as magnitude dependent on the frequency,

FIG. 10 is a diagram showing the characteristic of the digital filter according to the invention as group delay with respect to the sample period dependent on the frequency,

FIG. 11 is a diagram showing the characteristic of a digital filter according to the invention as magnitude dependent on the frequency for an increased reading speed and

FIG. 12 is a diagram showing the characteristic of the digital filter according to the invention as group delay with respect to the sample period dependent on the frequency for the increased reading speed and cut-off frequency.

DETAILED DESCRIPTION OF EMBODIMENTS

The invention is described exemplarily for an optical disc playback apparatus improving so-called playability or data detection performance from an optical disc. Reference signs are used with corresponding meanings through the Figures.

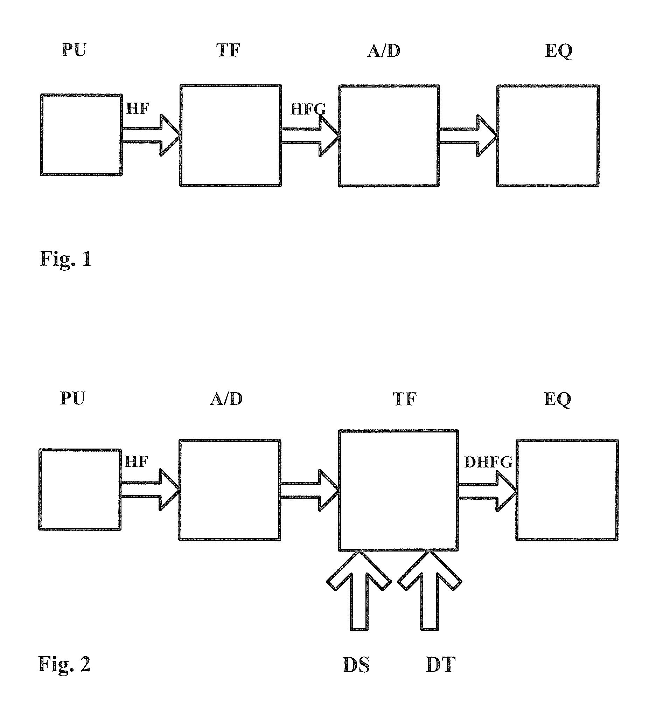

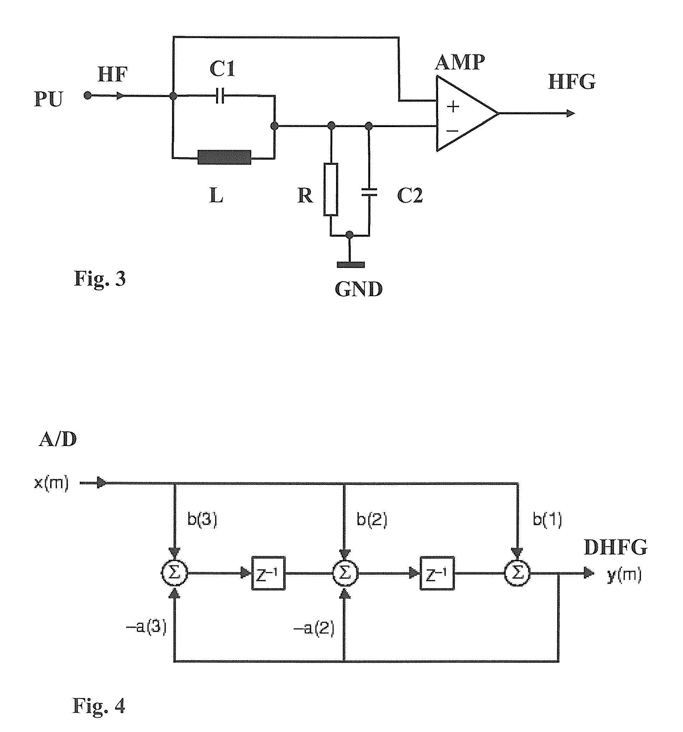

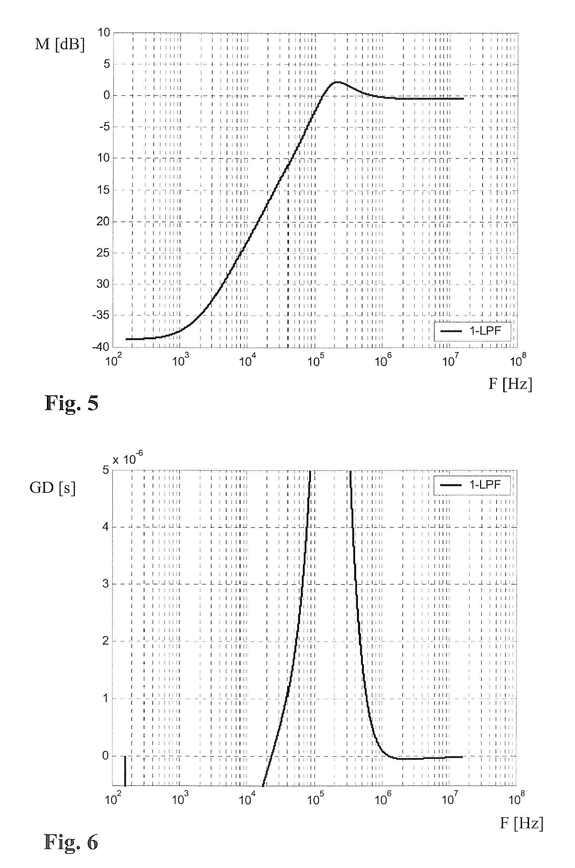

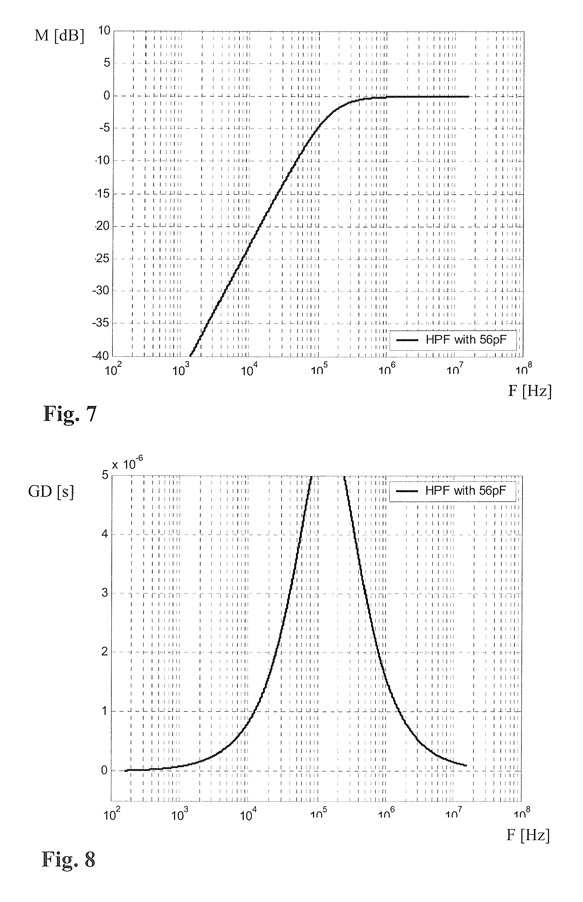

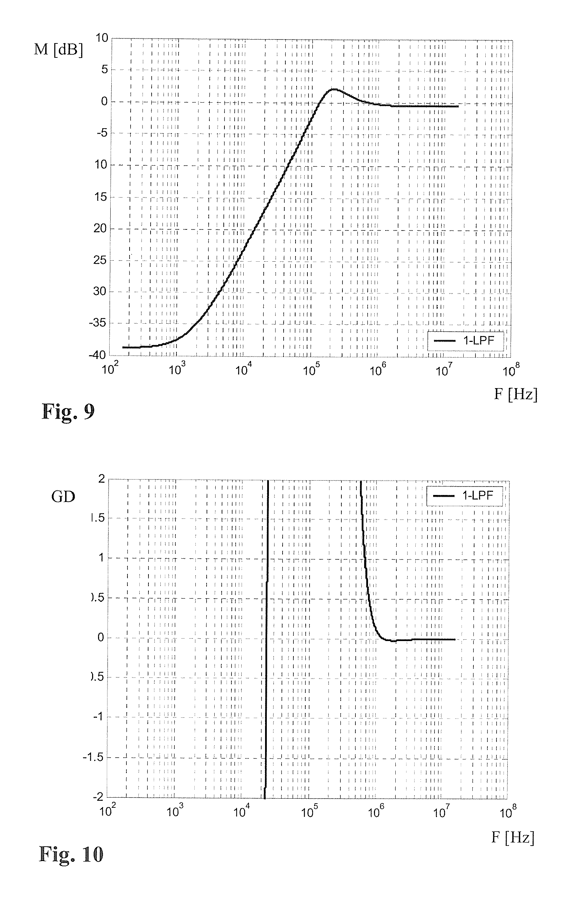

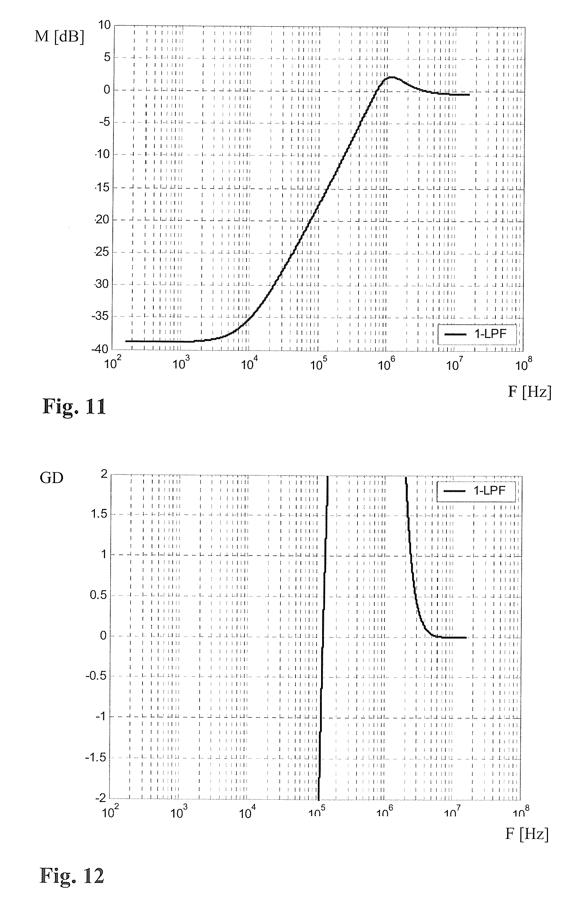

FIG. 1 illustrates a first embodiment of the invention, wherein a tuned filter TF is arranged in the signal pass between pickup PU and input of a front end in an optical disc playback apparatus for an improved playability of the disc. The pickup PU provides, amongst others, a high frequency signal HF, which contains the information stored on the disc and front end is the name of a stage in an optical playback apparatus that generates a digital bit stream from the signal read from the disc. The high frequency signal HF provided by the pickup PU is a so-called eye pattern, which represents the information stored on the disc as an analog high frequency signal HF. The eye pattern refers to the raw analog signal provided by the pickup as a reflection from the laser bouncing off the disc. The waveform of the signal that is read off the disc is very much analog. It is smooth and rounded and looks much like a sine wave but with flatter tops and bottoms. The undulating analog waveform should have high amplitude and steep zero crossings without temporal jitter, wander, or drift. There are many factors that can degrade the quality of this analog waveform, which interprets the playback apparatus in order to figure out where and exactly when bits or no bits are supposed to be placed in he digital signal created by the playback apparatus. If the disc is less reflective, there are fingerprints on the disc or the disc is dirty or scratched, then the amplitude will suffer and the zero crossings will not be as steep and well defined temporally or if some of the laser light is scattered into the disc and somehow later finds its way back to the photo detector, all this will make the signal corrupted. Especially fingerprints, dirt and small scratches lead to low frequency components in the high frequency signal HF provided by the pickup PU, which generate jitter and disturb the correct work of the waveform shaper or so-called data slicer in the front end part of the play back apparatus. Thus leads to a bad separation and phase shift of the different time signals T inherent in the high frequency signal HF provided by the pickup PU. Said time signals are symbols 3T to 11T in case of a CD and 3T to 14T in case of a DVD. It is well know to remove low frequency components in a signal by using a high pass filter. However, a high pass filter, which is formed by a capacitor between pickup PU and front end has the disadvantage that also the group delay GD increases for frequencies, in which information stored on the disc is included as shown in Fig. 7 and Fig. 8. FIG. 7 illustrates the attenuation of the magnitude M in decibel dB dependent on the frequency F in Hertz Hz for a high pass filter formed by a capacity of 56pF and front end input impedance of 20 kOhm. Fig. 8 illustrates the group delay GD dependent on the frequency F in Hertz Hz for said high pass filter. The symbols 3T to 14T of a DVD occur in a frequency range between 1 and 10 MHz if the DVD is reproduced at 1.5 speed. That means that such a high pass filter has a negative impact on signals representing the information stored on the disc in view of the group delay GD. Group delay GD is the negative of the rate of change of phase with frequency. The quantity of the group delay GD has the dimension of time, which in Fig. 6 and Fig 8 is seconds s and in Fig. 10 and 12 is related to the sample period. In view of the explanation given above, it is obvious that the group delay GD increases the error rate and decreases the quality of the signal, which the playback apparatus interprets as information stored on the disc. Therefore it is recommended to substitute the high pass filter by a tuned filter TF, which removes low frequency noise caused by a deteriorated signal level of the high frequency signal HF read from the optical disc and has a constant group delay GD for frequencies in the high frequency signal HF representing the information stored on the disc for an improved playability of the disc. This is achieved by forming a difference signal HFG from the high frequency signal HF read from the optical disc and the high frequency signal HF after passing a low pass filter. Said low pass filter is according to an embodiment of the invention a 2nd order elliptical filter and said difference signal HFG is formed by a tuned filter TF. As the frequency of the high frequency signal HF depends on the reading speed of the disc and the length of pits on the disc or in other words depends from the type of disc, the tuned filter TF has to be adapted to the type of optical disc and the current reading speed of the optical disc. A first example of the constitution of such a tuned filter TF is shown in Fig. 3. The optical pickup PU of the disc playback apparatus provides a high frequency signal HF direct applied to a non-inverting input + of a differential amplifier AMP and via a low pass filter applied to an inverting input - of the differential amplifier AMP. The differential amplifier AMP amplifies the difference between signals applied to the non-inverting input + and the inverting input - of the amplifier AMP and the low pass filter is formed by an inductance L in parallel to a first capacitor C1, which are serially arranged between pickup PU and inverting input - of the amplifier AMP as well as a resistor R in parallel to a second capacitor C2, which connect the inverting input - of the amplifier AMP to ground GND. The elements of the low pass filter have been selected for a 1.5 DVD reading speed in such a way that the low pass filter is an elliptical filter 2nd order with a cut-off frequency of 100 kHz, 0.1 dB of ripple in the pass-band and a stop-band 25 dB down from the peak value in the pass-band. Result is a tuned filter TF having a characteristic as shown in Fig. 5 and Fig. 6. A comparison between Fig. 5 and Fig. 7 illustrates that the tuned filter TF indicated by 1-LPF in Fig. 5 and a high pass filter HPF with 56 pf in Fig. 7 have nearly the same attenuation for corresponding frequencies, however, both have a complete different group delay GD as shown in Fig. 6 and Fig. 8. Fig. 6 illustrates that the group delay GD for frequencies above 1 MHz is constant and zero as desired. To be adaptable to disc type and reading speed, a second embodiment of the invention is illustrated in Fig. 2 and Fig. 4. According to a second embodiment of the invention, the tuned filter TF is realised by a digital filter being a finite-impulse-response digital filter forming the difference between the high frequency signal HF and the high frequency signal HF passing a low pass filter. The cut-off frequency of the low pass filter is the input parameter to calculate the filter coefficients adapted to the type of optical disc and the current reading speed of the optical disc. A 2nd order elliptical filter is also in this embodiment a preferred low pass filter. The tuned filter TF realised by a finite-impulse-response filter has a characteristic as shown in Fig. 9 and Fig 10, which is very similar to the characteristic as shown in Fig. 5 and Fig 6 for the first tuned filter realised as analog filter. The structure of a tuned filter TF realised by a finite-impulse-response or so-called FIR filter is shown in Fig. 4. The transfer function H of said FIR filter is

$$H(z) = \frac{Y(z)}{X(z)} = \frac{b_1 + b_2 \cdot z^{-1} + b_3 \cdot z^{-2}}{1 + a_2 \cdot z^{-1} + a_3 \cdot z^{-2}}$$

in z domain or in the time domain

$$y(m) = b_1 \cdot x(m) + b_2 \cdot x(m-1) + b_3 \cdot x(m-2) - a_2 \cdot y(m-1) - a_3 \cdot y(m-2),$$

wherein x(m) represents samples of the analog/digital converted high frequency signal HF, y(m) represents the samples provided at the output of the FIR filter, and a and b with index represent filter coefficients. Similar to the first embodiment, the FIR filter provides a digital difference signal DHFG formed from the high frequency signal HF read from the optical disc and the high frequency signal HF passing the low pass filter. Input parameter for calculating filter coefficients a and b with index for different disc types and different reading speeds is the cut-off frequency of the low pass filter, which in the shown embodiment is a 2nd order elliptical filter. The filter coefficients of the FIR filter can be calculated with known tools like so-called matlab and in the illustrated embodiment a cut-off frequency of 100 kHz for a DVD read at 1.5 speed as well as a sampling rate of 80 MHz have been used to provide a filter characteristic as illustrated in Fig. 9 and Fig. 10. In case of a higher reading speed, it is very easy to move the complete characteristic of the tuned filter TF to higher frequencies in the frequency spectrum as it is illustrated for an 8 time reading speed and a cut-off frequency of 533 kHz in Fig. 11 and Fig. 12. The FIR filter, which forms the tuned filter TF, is via an analog/digital converter A/D applied to the optical pickup PU providing the high frequency signal HF as shown in Fig. 2. In such a way, a general solution adaptable to disc type DT and current disc speed DS is formed, which improves the playability of an optical disc and increases the quality of the signal representing information stored on the disc. The output of the tuned filter TF provides a difference signal HFG or a digital difference signal DHFG as shown above, wherein low frequency noise has been removed and frequency signals representing the information stored on the disc have a constant group delay GD. Afterwards, the signal or the samples provided at the output of the tuned filter TF can be furthermore improved as e.g by correcting an offset voltage of the provided signal to obtain correct slicing of the eye pattern signal in further stages of an optical playback apparatus as e.g. a front end device or an equalizer EQ shown in Fig. 1 and Fig. 2.

The tuned filter TF can be used and configured in numerous different ways, with the result that the field of application and the implementation of the invention are not restricted to the exemplary embodiments specified here.

**Claims**

1. Optical disc playback apparatus comprising:

   - an optical pickup (PU) which provides a high frequency signal (HF) read from an optical disc and
   - a tuned filter (TF) adapted to the type of optical disc and the current reading speed of the optical disc, wherein
   - the tuned filter (TF)
   - removes low frequency noise caused by a deteriorated signal level of the high frequency signal (HF) read from the optical disc and
   - has a constant group delay (GD) for frequencies in the high frequency signal (HF) read from the optical disc representing the information stored on the disc for an improved playability of the disc.

2. Optical disc playback apparatus according to claim 1, wherein the tuned filter (TF) is an analogue filter applied to the optical pickup (PU) comprising a differential amplifier (AMP) having a non-inverting input (+) connected to the optical pickup (PU) and an inverting input (-) via a low pass filter connected to the optical pickup (PU).

3. Optical disc playback apparatus according to claim 2, wherein the low pass filter is formed by an inductance (L) in parallel to a first capacitor (C1), which are serially arranged between pickup (PU) and inverting input (-) of the amplifier (AMP), and a resistor (R) in parallel to a second capacitor (C2), which connect the inverting input (-) of the amplifier (AMP) to ground GND.

4. Optical disc playback apparatus according to claim 1, wherein the tuned filter (TF) is an analogue filter applied to the optical pickup (PU), which provides the difference between the high frequency signal (HF) and the high frequency signal (HF) passing a low pass filter.

5. Optical disc playback apparatus as set forth in claim 1, wherein the tuned filter (TF) is a digital filter being applied via an analog/digital converter (A/D) to the optical pickup (PU) providing the high frequency signal (HF), the digital filter being a finite-impulse-response digital filter forming the difference between the high frequency signal (HF) and the high frequency signal (HF) passing a low pass filter and the cut-off frequency of the low pass filter is the input parameter to calculate the filter coefficients adapted to the type of optical disc and the current reading speed of the optical disc.

6. Optical disc playback apparatus according to one of the claims 2 to 5, wherein the low pass filter is a $2^{nd}$ order elliptical filter.

7. Method to improve the playability of an optical disc, wherein a difference signal (HFG) between a high frequency signal (HF) read from an optical disc and the high frequency signal (HF) passing a low pass filter is formed and the cut-off frequency of the low pass filter is adapted to the type of optical disc and the current reading speed of the optical disc to remove low frequency noise caused by a deteriorated signal level of the high frequency signal (HF) read from the optical disc and to provide a constant group delay (GD) for frequencies in the high frequency signal (HF) read from the optical disc representing the information stored on the disc for an improved playability of the disc.

8. Method according to claim 7, wherein the low pass filter is a $2^{nd}$ order elliptical filter.

| PU | TF | A/D | EQ |
|---|---|---|---|

HF          HFG

**Fig. 1**

| PU | A/D | TF | EQ |
|---|---|---|---|

HF                    DHFG

DS          DT

**Fig. 2**

Fig. 3

Fig. 4

**Fig. 5**

**Fig. 6**

**Fig. 7**

**Fig. 8**

Fig. 9

Fig. 10

**Fig. 11**

**Fig. 12**

**European Patent Office**

## EUROPEAN SEARCH REPORT

Application Number

EP 06 11 7228

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | EP 0 883 124 A2 (PIONEER ELECTRONIC CORP [JP]) 9 December 1998 (1998-12-09) * page 2, line 45 - page 8, line 45; figures 1,12 * | 1 | INV. G11B20/10 |
| Y | * page 2, line 45 - page 8, line 45; figures 1,12 * ----- | 2-8 | |
| Y | US 5 097 235 A (REICHEL THOMAS [DE]) 17 March 1992 (1992-03-17) * column 1, line 40 - column 7, line 21; figures 1,9 * ----- | 2-8 | |
| Y | DE 195 33 946 A1 (RICHT STEFAN DIPL ING [DE]) 27 June 1996 (1996-06-27) * column 1, lines 1-63 * ----- | 2-8 | |
| Y | EP 0 789 448 A1 (NOKIA MOBILE PHONES LTD [FI] NOKIA CORP [FI]) 13 August 1997 (1997-08-13) * column 5, lines 37-45; figures 3,7 * ----- | 3 | |
| Y | US 2005/116676 A1 (GEISSDORFER KLAUS [DE] ET AL GEISSDOERFER KLAUS [DE] ET AL) 2 June 2005 (2005-06-02) * paragraphs [0020] - [0048] * ----- | 5,7 | TECHNICAL FIELDS SEARCHED (IPC) G11B |
| Y | JP 62 190983 A (VICTOR COMPANY OF JAPAN) 21 August 1987 (1987-08-21) * abstract; figures 1,2 * ----- | 2-8 | |

The present search report has been drawn up for all claims

| Place of search | Date of completion of the search | Examiner |
|---|---|---|
| Munich | 13 December 2006 | Baur, Christoph |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

**EP 1 879 190 A1**

**ANNEX TO THE EUROPEAN SEARCH REPORT
ON EUROPEAN PATENT APPLICATION NO.**

EP 06 11 7228

This annex lists the patent family members relating to the patent documents cited in the above-mentioned European search report.
The members are as contained in the European Patent Office EDP file on
The European Patent Office is in no way liable for these particulars which are merely given for the purpose of information.

13-12-2006

| Patent document cited in search report | | Publication date | Patent family member(s) | | Publication date |
|---|---|---|---|---|---|
| EP 0883124 | A2 | 09-12-1998 | DE | 69808175 D1 | 31-10-2002 |
| | | | DE | 69808175 T2 | 22-05-2003 |
| | | | JP | 10334602 A | 18-12-1998 |
| | | | US | 6212155 B1 | 03-04-2001 |
| US 5097235 | A | 17-03-1992 | DE | 4000131 C1 | 18-04-1991 |
| | | | GB | 2239753 A | 10-07-1991 |
| DE 19533946 | A1 | 27-06-1996 | NONE | | |
| EP 0789448 | A1 | 13-08-1997 | DE | 69712936 D1 | 11-07-2002 |
| | | | DE | 69712936 T2 | 23-01-2003 |
| | | | GB | 2310115 A | 13-08-1997 |
| | | | US | 5917867 A | 29-06-1999 |
| US 2005116676 | A1 | 02-06-2005 | DE | 10355614 A1 | 07-07-2005 |
| JP 62190983 | A | 21-08-1987 | NONE | | |

EPO FORM P0459

For more details about this annex : see Official Journal of the European Patent Office, No. 12/82

14